# EUROPEAN PATENT APPLICATION

(11) **EP 2 263 792 A1**
(43) Date of publication of application: **22.12.2010**
(21) Application number: 09718093.9
(22) Date of filing: 06.03.2009
(51) Int. Cl.: B01J 19/00, B01D 53/68, C08J 7/12, C23C 8/08, H01L 21/3065

(54) **SURFACE TREATMENT APPARATUS**

(30) Priority: 06.03.2008 JP 2008056951; 06.03.2008 JP 2008056952
(71) Applicant: Toyo Tanso Co., Ltd., Osaka-shi Osaka 555-0011 (JP)
(72) Inventor: HIRAIWA, Jiro, Osaka-shi Osaka 555-0011 (JP); TAKEBAYASHI, Hitoshi, Osaka-shi Osaka 555-0011 (JP); YOSHIMOTO, Osamu, Osaka-shi Osaka 555-0011 (JP); TANAKA, Noriyuki, Osaka-shi Osaka 555-0011 (JP); FUJITA, Ichiro, Osaka-shi Osaka 555-0011 (JP); SASAKI, Hiroyoshi, Takamatsu-shi Kagawa 760-0065 (JP); MORI, Kazutaka, Takamatsu-shi Kagawa 760-0065 (JP)
(74) Representative: TBK-Patent
(86) International application number: PCT/JP2009/054331
(87) International publication number: WO 2009/110611

(57) **Abstract**

A surface treatment apparatus 100 includes a diluent gas supplier 1, a fluorine gas supplier 2, a mixer 5 which mixes a diluent gas with a fluorine gas, and a reactor 6 which treats a treatment target by using a mixed gas generated by the mixer 5. A diluent gas supplied from a diluent gas supplier is heated by a heater 8, and the heated diluent gas is mixed with a fluorine gas supplied from a fluorine gas supplier, in the mixer 5. The mixed gas is supplied to the reactor 6. The gas in the reactor 6 is supplied from the reactor 6 to flow paths 219, 220, 221, and 222 by an exhauster 207. The valves 223, 224, 225, and 226 are serially opened, so that the gas in the reactor 6 is supplied to a harm removal apparatus 208 while the gas flow rate is being adjusted by the flow paths 219, 220, 221, and 222.

## Description

### TECHNICAL FIELD

The present invention relates to a surface treatment apparatus which conducts surface treatment, surface modification or the like of samples by using a fluorine gas.

### BACKGROUND ART

Surface modification and surface treatment of organic matters or the like by a fluorine gas have conventionally been conducted, and a known example thereof is a surface treatment apparatus recited in the patent document below. The surface treatment apparatus recited in Patent Document 1 includes a gas regulation tank having supply pipes connected to a fluorine gas source and an inert gas source, a treatment tank connected to the gas regulation tank by a gas conduit, and an exhaust gas treatment apparatus. This surface treatment apparatus is suitable for small-scale surface treatment and surface treatment using a lean fluorine gas.

[Patent Document 1] Japanese Unexamined Patent Publication No. 2000-319433

### DISCLOSURE OF THE INVENTION

### [PROBLEMS TO BE SOLVED BY INVENTION]

Regarding the apparatus above, when surface treatment is conducted using a treatment tank having a large capacity, treatment irregularities may occur because of reasons such as the position of a treatment target in the treatment tank, gas passages, and stagnation of gas. To prevent such treatment irregularities, for example, there is a method arranged such that surface treatment is conducted under a heated condition by using a heating unit which is provided in the treatment tank and heats the treatment target to a predetermined temperature. However, treatment irregularities may occur even in such an apparatus, due to a temperature difference between the treatment target and a mixed gas supplied to treat the treatment target, in the treatment tank. In addition to this, when a mixed gas is introduced into the treatment tank, a highly-reactive fluorine gas included in the mixed gas starts the reaction immediately after the introduction of the mixed gas, and this may cause treatment irregularities. In particular, when the treatment tank has a large capacity, surface treatment starts from around the gas introducing part before the mixed gas is evenly dispersed in the treatment tank and the conditions become uniform in the treatment tank, with the result that treatment irregularities may occur. To restrain such a problem, a mixed gas heated in advance may be supplied to the treatment tank to restrain a temperature difference between the treatment target and the mixed gas. This scheme, however, is disadvantageous in that it is necessary to rapidly heat the mixed gas in the short passage to the reactor, and it is also necessary to heat the mixed gas from the outside of the pipe through which the gas flows, at a high temperature which is higher by several tens of degrees than a desired heating (treatment) temperature. For this reason, since the temperature of the fluorine gas included in the mixed gas is rapidly increased and this high temperature further increases the reactivity of the fluorine gas, localized damages such as corrosion may occur due to the high reactivity, even if the metal components in the gas conduits, valves, or the like and resin components used as gaskets inside the metal components are made of materials having high corrosion resistance.

In addition to the above, regarding the apparatus above it is pointed out that the gas in the treatment tank after the surface treatment often includes a fluorine gas, and an amount of the fluorine gas may be large when the treatment tank is large. It has been known that fluorine gas exhibits high reactivity, toxicity, and corrosiveness. When a gas including a large amount of fluorine gas is exhausted at once from the treatment tank, loads are applied on the pipes, components, devices, harm removal agent and the like on the downstream of the treatment tank for the reasons such as an increase in an amount of heat of the harm removal agent by which the fluorine gas is treated, with the result that local heat generation may occur and the pipes or the like may be corroded. In particular, when an exhauster for exhausting gas from the reactor is provided on the downstream of the reactor, the pump of the exhauster may be damaged.

In consideration of the above, an objective of the present invention is to provide a surface treatment apparatus which can prevent components of the apparatus from being damaged and prevent treatment irregularities of a treatment target from occurring. Another objective of the present invention is to provide a surface treatment apparatus which can prevent the apparatus from being damaged by a gas used for surface treatment and/or surface modification.

### [MEANS FOR SOLVING THE PROBLEMS]

A surface treatment apparatus of the present invention preferably includes: a diluent gas supplier which supplies a diluent gas; a fluorine gas supplier which supplies a fluorine gas; a mixer which generates a mixed gas by mixing the diluent gas with the fluorine gas; a surface treatment apparatus which includes a reactor causing the mixed gas to contact a treatment target; and a surface treatment apparatus which includes a heating unit heating the diluent gas. In particular, it is preferable that the heating unit heats the diluent gas before the diluent gas is mixed with the fluorine gas.

According to the arrangement above, since a diluent gas is heated by the heater and the heated diluent gas is mixed with a fluorine gas, the fluorine gas is not heated to an excessively high temperature, and hence damages such as corrosion of components constituting the apparatus are prevented. Furthermore, it is possible to provide a surface treatment apparatus which prevents treatment irregularities of a treatment target, because a heated mixed gas is supplied to the reactor.

In addition to the above, the surface treatment apparatus of the present invention preferably includes an ejector which sucks the fluorine gas by using the diluent gas as a drive source. This ejector is able to suck a gas by increasing the flow rate and generating a decompressed state.

According to the arrangement above, the ejector makes it possible to suck a fluorine gas from the fluorine gas supplier by using a diluent gas as a drive source. Since the supply pressure of the fluorine gas is decreased as a result of this, it becomes unnecessary to store fluorine gas with a high pressure, and hence fluorine gas is stored and used safely. Furthermore, it is possible to supply a precise amount of fluorine gas which is smaller in supply amount than diluent gas.

In addition to the above, the surface treatment apparatus of the present invention preferably includes: a first flow control unit which is connected to the diluent gas supplier and the mixer; pressure gauges which are provided on the upstream and downstream of the first flow control unit, respectively; and a pressure adjusting valve which is connected to the diluent gas supplier and the pressure gauge on the upstream of the first flow control unit.

According to the arrangement above, since a constant driving pressure difference is applied to the first flow control unit by the pressure adjusting valve, it is possible to supply a diluent gas at a constant flow rate without being influenced by the pipes on the downstream of the diluent gas supplier and the first flow control unit and pressures such as an internal pressure of the reactor. An example of the first flow control unit is a mass flow controller. The mass flow controller precisely controls the mass flow of a gas by means of an electric signal. Since the mass flow of the diluent gas is controllable, it is possible to precisely and stably control the flow rate of the diluent gas without being influenced by temperatures and supply pressures.

In addition to the above, the surface treatment apparatus of the present invention preferably includes a pressure dampening tank which is provided between the pressure adjusting valve and the pressure gauge on the upstream of the first flow control unit.

According to the arrangement above, the pressure dampening tank dampens the interaction between the pressure adjusting valve and the valve on the first flow control unit, and hence the accuracy of the flow rate is further improved.

In addition to the above, the surface treatment apparatus of the present invention preferably includes a second flow control unit connected to the fluorine gas supplier and the mixer via a pipe.

According to the arrangement above, since the second flow control unit makes it possible to precisely control the mass flow of fluorine gas by an electric signal, it is possible to further precisely and stably control the flow rate of the fluorine gas without being influenced by temperatures and supply pressures. An example of the second flow control unit is a mass flow controller, in the same manner as the first flow control unit.

In addition to the above, the surface treatment apparatus of the present invention preferably includes: a first communicating tube which is connected to the mixer; a back pressure valve which is provided at a non-edge part of the first communicating tube; a gas discharge valve which is provided at a non-edge part of the first communicating tube, the non-edge part being on the downstream of the back pressure valve; a second communicating tube which connects the mixer with the reactor; and a gas introducing valve which is provided at a non-edge part of the second communicating tube.

According to the arrangement above, until the driving pressure difference for generating a sufficient vacuum in the ejector is generated and the flow rate of the diluent gas is stabilized, the gas introducing valve is closed and the gas discharge valve is opened, and the diluent gas and/or fluorine gas is discharged via the first communicating tube. After the flow rate of the diluent gas is stabilized, the gas discharge valve is closed and the gas introducing valve is opened, so that the mixed gas is introduced into the reactor via the second communicating tube. As a result, it is possible to supply to the reactor a mixed gas whose flow rate and density are adjusted to be constant, right after the start of the supply.

In addition to the above, the surface treatment apparatus of the present invention includes: a diluent gas supplier which supplies a diluent gas; a fluorine gas supplier which supplies a fluorine gas; a mixer which generates a mixed gas by mixing the diluent gas with the fluorine gas; a surface treatment apparatus which includes a reactor which causes the mixed gas to contact a treatment target; an exhauster which exhausts an exhaust gas from the reactor; plural flow paths which are provided between the reactor and the exhauster and through which the exhaust gas passes; and plural valves which are provided on the flow paths, respectively. It is preferable that a harm removal apparatus which is connected to the exhauster is further included.

According to the arrangement above, by suitably opening and/or closing the valves, it is possible to introduce a gas to the exhauster and the harm removal apparatus at a desired flow rate, by suitably switching flow paths having difference diameters and/or by suitably changing the number of used flow paths. With this, even if a large amount of gas including fluorine gas is exhausted from the reactor, it is possible to prevent the large amount of gas from being introduced into the exhauster and the harm removal apparatus at once, by using the flow paths and the valves, thereby preventing a problem of partial corrosion and rapid deterioration which occur because a large amount of fluorine gas increases the heat generation of the harm removal agent and hence the pipes, components, devices, harm removal agent and the like on the downstream of the reactor are loaded. Furthermore, because the exhauster is provided, it becomes easy to exhaust gas from the reactor. Furthermore, since the fluorine gas and hydrogen fluoride gas in the gas exhausted from the reactor are removed by the harm removal apparatus and the gas whose flow rate is adjusted and controlled to be a desired value is introduced into the harm removal apparatus, it is possible to consume and replace the harm removal agent filling the harm removal apparatus efficiently and precisely, and hence the costs for replacing parts and components of the surface treatment apparatus are further restrained. Because of the above, it is possible to provide a surface treatment apparatus which is able to prevent the apparatus from being damaged by the gas exhausting after the surface treatment.

In addition to the above, the surface treatment apparatus of the present invention is preferably arranged so that each of components existing in a range from an outlet of the reactor to an inlet of the harm removal apparatus has a heating/heat-retaining unit, and an internal temperature of each of the components is equal to or higher than the boiling temperature of hydrogen fluoride.

When the hydrogen fluoride gas generated by the surface treatment and/or surface modification is mixed into the fluorine gas, the metal parts of the pipes and valves are corroded and/or deteriorated, and such corrosion and deterioration are facilitated when the hydrogen fluoride gas is liquefied. According to the arrangement above, since the internal temperatures of the pipes and components from the outlet of the reactor to the inlet of the harm removal apparatus are kept to be not lower than the boiling temperature of the hydrogen fluoride, it is possible to prevent the hydrogen fluoride gas in the gas exhausted from the reactor from being liquefied. It is therefore possible to further restrain the corrosion and deterioration of the metal parts constituting the pipes and components or the like, and to introduce the fluorine gas and hydrogen fluoride gas to the harm removal apparatus without the liquefaction thereof.

In addition to the above, the surface treatment apparatus of the present invention is preferably arranged so that the harm removal apparatus includes plural harm removal towers, and among the plural harm removal towers, at least one of the harm removal towers is independently connected, whereas the remaining at least two towers different from the independently-connected tower are connected in series with each other.

According to the arrangement above, in the harm removal apparatus, it is possible to perform replacement of the harm removal agent or maintenance of the one tower for future use while the two towers are continuously in use. Furthermore, since two harm removal towers can be continuously in use, it is possible to keep the harm removal towers in a safe state while the operation of the surface treatment apparatus is continued.

In addition to the above, the surface treatment apparatus of the present invention preferably includes: a heating chamber which heats the treatment target.

According to the arrangement above, since the treatment target is heated in advance in the heating chamber before contacting the mixed gas, it is possible to restrain treatment irregularities and improper treatments. Also, since the treatment target is heated in advance, the time required for heating the treatment target in the reactor is shortened, with the result that cost reduction is achieved and the treatment efficiency is further improved.

In addition to the above, the surface treatment apparatus of the present invention preferably includes: a movable member which is capable of transporting the treatment target into the reactor and has fluorine gas corrosion resistance.

According to the arrangement above, the treatment target is easily transported into or from the reactor, and prevents the fluorine gas included in the mixed gas from generating impurities from the movable member.

In addition to the above, the surface treatment apparatus of the present invention preferably includes: in the reactor, a plate member which is provided between the treatment target and the mixed gas supplied to the reactor. In another aspect, a plate member is preferably provided on the movable member and between the treatment target and the mixed gas supplied to the reactor.

According to the arrangement above, the mixed gas hardly contacts the treatment target directly around the mixed gas introducing part of the reactor, with the result that treatment irregularities of the treatment target are restrained and the treatment target is uniformly treated.

### [EFFECTS OF THE INVENTION]

The surface treatment apparatus of the present invention can prevent fluorine gas from heated to an excessively high temperature. For this reason, damages on components by the fluorine gas are restrained and hence treatment irregularities of the treatment target is restrained. In addition to this, the surface treatment apparatus of the present invention makes it possible to exhaust a desired amount of fluorine gas used for the surface treatment by using plural flow paths, and hence it is possible to prevent a large amount of fluorine gas from being exhausted at once. It is therefore possible to prevent the apparatus from being damaged by the gas used for the surface treatment and surface modification.

### BRIEF DESCRIPTION OF THE DRAWINGS

Fig. 1 outlines an essential part of a surface treatment apparatus according to First Embodiment of the present invention.
Fig. 2 is a schematic cross section of the reactor of Fig. 1.
Fig. 3 outlines an essential part of a surface treatment apparatus according to Second Embodiment of the present invention.
Fig. 4 outlines a reactor of a modification.
Fig. 5 outlines an essential part of a surface treatment apparatus according to a modification of the present invention.

### REFERENCE NUMERALS

1 DILUENT GAS SUPPLIER
2 FLUORINE GAS SUPPLIER
3a, 3b MASS FLOW CONTROLLER
4 EJECTOR
5 MIXER
6, 36 REACTOR
7 HARM REMOVAL APPARATUS
8 HEATER
9, 10 PRESSURE GAUGE
11 PRESSURE ADJUSTING VALVE
12 PRESSURE DAMPENING TANK
13, 214 FIRST COMMUNICATING TUBE
14, 414 BACK PRESSURE VALVE
15 GAS DISCHARGE VALVE
16 SECOND COMMUNICATING TUBE
17 GAS INTRODUCING VALVE
18, 38 MIXED GAS SUPPLY OPENING
19, 39 MIXED GAS EJECTION OPENING
20, 40, 343 PLATE MEMBER
21, 341 TREATMENT TARGET
22, 342 MOVABLE MEMBER
23, 336b HEATING CHAMBER
336a REACTION CHAMBER
100,200 SURFACE TREATMENT APPARATUS
207 EXHAUSTER
208 HARM REMOVAL APPARATUS
208a, 208b, 208c HARM REMOVAL TOWER
219, 220, 221, 222 FLOW PATH
223, 224, 225, 226 VALVE
250 HEATING/HEAT-RETAINING APPARATUS

### BEST MODE FOR CARRYING OUT THE INVENTION

The following will describe a preferred embodiment of the present invention with reference to figures.

### <First Embodiment>

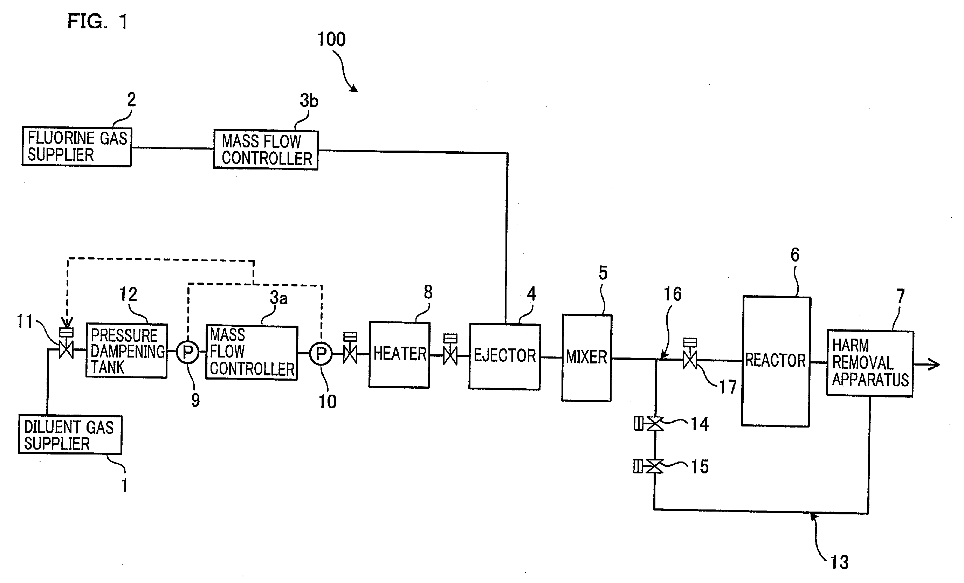

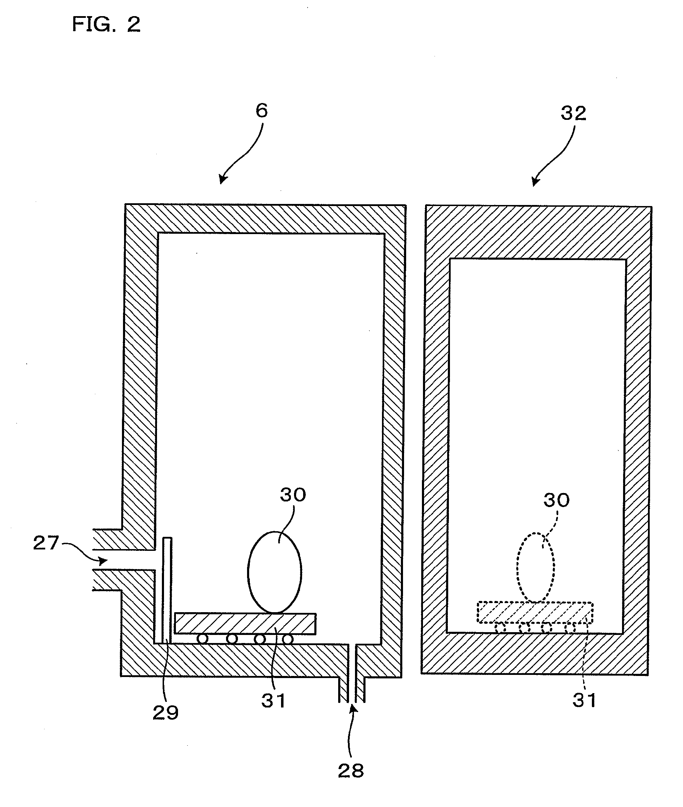

A surface treatment apparatus according to First Embodiment of the present invention will be described. Fig. 1 outlines an essential part of the surface treatment apparatus of the embodiment of the present invention, whereas Fig. 2 is a schematic cross section of the reactor of Fig. 1.

As shown in Fig. 1, a surface treatment apparatus 100 includes a diluent gas supplier 1, a fluorine gas supplier 2, a mass flow controller (first flow control unit) 3a which is connected to the diluent gas supplier 1 by a pipe, a mass flow controller (second flow control unit) 3b which is connected to the fluorine gas supplier 2 via a pipe, an ejector 4 connected to the mass flow controllers 3a and 3b by pipes, a mixer 5 which is connected to the ejector 4 by a pipe and is provided downstream of the ejector 4, a reactor 6 which treats a treatment target by a mixed gas supplied from the mixer 5, and a harm removal apparatus 7 which removes a fluorine gas and a hydrogen fluoride gas included in the gas introduced from the reactor 6, and in this apparatus a heater (heating unit) 8 is provided between the mass flow controller 3a and the ejector 4. On the upstream and downstream of the mass flow controller 3a, pressure gauges 9 and 10 are provided, respectively. Further upstream of the pressure gauge 9, a pressure adjusting valve 11 and a pressure dampening tank 12 are provided. The surface treatment apparatus 100 further includes a second communicating tube 16 connected to the mixer 5 and the reactor 6, a gas introducing valve 17 provided at a non-edge portion of the second communicating tube 16, a first communicating tube 13 branching from a non-edge portion of the second communicating tube 16, and a back pressure valve 14 and a gas discharge valve 15 which are provided at non-edge portions of the first communicating tube 13.

The diluent gas supplier 1 supplies gas such as inert gas, by which fluorine gas is diluted. Non-limiting examples of diluent gas include nitrogen gas, oxygen gas, and argon gas.

The fluorine gas supplier 2 supplies fluorine gas. Examples of this fluorine gas supplier include a fluorine gas generator which generates a fluorine gas by supplying hydrogen fluoride from an unillustrated hydrogen fluoride supplier and electrolyzing the hydrogen fluoride and a gas cylinder filled with a fluorine gas.

The mass flow controllers (first flow control unit and second flow control unit) 3a and 3b precisely control gas mass flow by means of electric signals. These apparatuses make it possible to precisely and stably control the flow of diluent gas and fluorine gas without being influenced by temperatures and supply pressures. In the mass flow controllers 3a and 3b, a gas pressure difference between the inlet and outlet must be in the range of 0.05-0.10MPa to achieve the flow control. Without this pressure difference, it is impossible to precisely conduct the flow control on account of pressure loss inside the mass flow controllers 3a and 3b. In this regard, a diluent gas and a fluorine gas are not properly supplied via the mass flow controllers 3a and 3b, when the inlet pressure is not lower than a pressure calculated by adding up (i) the treatment pressure (e.g. atmospheric pressure) of the reactor 6 downstream of the mass flow controllers 3a and 3b, (ii) a pressure loss (e.g. 0.05-0.10MPa) in the mass flow controllers 3a and 3b, and (iii) a pressure difference (e.g. 0.05-0.10MPa) required to push out required amounts of diluent gas and fluorine gas from the sources which are diluent gas supplier 1 and fluorine gas supplier 2. The inlet pressure above is, for example, higher than the atmospheric pressure by 0.10-0.20MPa. In connection with this, a combination of the ejector 4 and the mass flow controllers 3a and 3b makes it possible to lower the outlet pressure of the mass flow controllers 3a and 3b by the suction power of the ejector 4, and hence (because the pressure of the reactor 6 is negligible in this case) the pressure required for driving the inlets of the mass flow controllers 3a and 3b is reduced. On this account, the pressure for retaining and supplying the fluorine gas is lowered as much as the capability of the ejector. Since the fluorine gas is highly reactive, the danger of corrosion and gas leakage is restrained when the retaining pressure is lowered.

The ejector 4 sucks gas by creating a decompressed state by increasing the flow rate. This component makes it possible to surely suck a fluorine gas by using a diluent gas as a drive source. The sucked gas is introduced into the mixer 5. In place of the ejector 4, a vacuum generator may be used, for example. With this ejector 4, the upper limit of the pressure of the fluorine gas supplier 2 with which the fluorine gas is suitably supplied is 200kPa, and the lower limit is -65kPa(G).

The mixer 5 mixes the diluent gas and the fluorine gas sucked by the ejector 4, and introduces the mixed gas to the reactor 6. Alternatively, the mixed gas may be generated such that the ejector 4 sucks the fluorine gas by using the diluent gas as a drive source.

The reactor 6 receives the mixed gas of diluent gas and fluorine gas to perform surface treatment and modification of the treatment target. More specifically, as shown in Fig. 2, the reactor 6 has a mixed gas supply opening 18 and a mixed gas ejection opening 19, and inside the reactor 6 are provided a plate member 20, a treatment target 21, and a movable member 22. Along with the reactor 6, a heating chamber 23 is also provided.

The plate member 20 is arranged in a standing manner in the reactor 6 to block the supplied gas, between the mixed gas supply opening 18 and the treatment target 21. This plate member 20 may be provided on the movable member 22 or may be detachable. The plate member 20 restrains the mixed gas to directly contact the treatment target 21 around the mixed gas supply opening 18 of the reactor 6, thereby restraining the treatment irregularities and improper treatments.

The movable member 22 is capable of moving the treatment target 21 to the inside or outside of the reactor 6, and is preferably made of a metal material having fluorine gas corrosion resistance, e.g. a mesh or punched metal made of stainless steel or the like. The movable member 22 is provided with wheels; alternatively, no wheels may be attached. As another modification, the metal components may be a mesh or punched metal, a metal frame, and wheels.

The heating chamber 23 is provided for heating the treatment target 21 in advance before causing the treatment target 21 to contact the mixed gas. Since it is preferable that the treatment target 21 contacts the mixed gas and is treated while being heated, the treatment target 21 is preferably transferred from the heating chamber 23 to the reactor 6 quickly. The heating chamber 23 is therefore preferably provided around the reactor 6, and the heating chamber 23 may be connected to the reactor 6. As modifications, the heating chamber 23 may be adjacent to the reactor 6, and the heating chamber 23 may be provided in the reactor 6.

The harm removal apparatus 7 detoxifies the gas exhausted from the reactor 6 by removing hydrogen fluoride gas and fluorine gas generated from the surface of the treatment target 21 as a result of the surface treatment by the reactor 6. The gas from which the fluorine gas and hydrogen fluoride gas have been removed by the harm removal apparatus 7 is exhausted to the outside of the surface treatment apparatus 100. To remove the fluorine gas and hydrogen fluoride gas, the apparatus 7 may be filled with soda lime, for example.

The heater (heating unit) 8 is provided at a non-edge portion of the pipe connecting the diluent gas supplier 1 with the ejector 4, and heats the diluent gas supplied from the diluent gas supplier 1. The diluent gas is heated before mixing the diluent gas with the fluorine gas. An example of the heater (heating unit) 8 is a heater.

The pressure gauge 9 measures a pressure on the upstream of the mass flow controller 3a, and is provided on the upstream of the mass flow controller 3a. The pressure gauge 10 measures a pressure on the downstream of the mass flow controller 3a, and is provided on the downstream of the mass flow controller 3a.

The pressure adjusting valve 11 puts a constant driving pressure difference to the mass flow controller 3a in accordance with a difference between the pressure of the pressure gauge 9 and the pressure of the pressure gauge 10. The pressure adjusting valve 11 is provided between the diluent gas supplier 1 and the pressure dampening tank 12 and connected with them by a pipe. With this arrangement, the pressure adjusting valve 11 is capable of supplying the diluent gas with a pressure higher than the sum of the maximum pressure on the downstream side of the ejector 4, the driving pressure difference of the ejector 4, the driving pressure difference of the mass flow controller 3a, and the pressure loss in each of the components constituting the surface treatment apparatus 100. In addition to the above, when the supply (flow rate) of the diluent gas is fixed by the mass flow controller 3a, no pressure difference is generated on the upstream side and the downstream side of the ejector 4, and a pressure is generated only when the diluent gas is supplied. On this account, the pressure differences on the upstream and downstream of the mass flow controller 3a before the supply of the diluent gas often exceed the driving pressure difference, with the result that a valve (not illustrated) of the mass flow controller 3a is closed and the supply of the diluent gas may be impossible. In such a case, it is possible to supply the diluent gas in such a way that the flow rate of the diluent gas is adjusted by the pressure adjusting valve 11 to put a constant driving pressure difference to the upstream and downstream of the mass flow controller 3a.

Now, valve hunting occurring in the valve of the mass flow controller 3a and the pressure adjusting valve 11 will be detailed. When the flow rate of the diluent gas is low, the valve of the mass flow controller 3a is opened so that the flow rate increases whereas the driving pressure difference decreases. As a result of this, the pressure adjusting valve 11 is opened to secure the pressure and hence the pressure increases, whereas the flow rate of the diluent gas exceeds a setting value and hence the valve (not illustrated) of the mass flow controller 3a is closed. Consequently, the driving pressure difference increases and the pressure adjusting valve 11 is closed, and hence the driving pressure difference decreases and the flow rate of the diluent gas also decreases.

The pressure dampening tank 12 is provided between the pressure adjusting valve 11 and the pressure gauge 9 via a pipe, and is capable of storing the diluent gas supplied from the diluent gas supplier 1. This pressure dampening tank 12 makes it possible to prevent the flow rate accuracy of the diluent gas from being lowered when the hunting of the unillustrated valve of the mass flow controller 3a and the pressure adjusting valve 11 occurs due to, for example, a combination of a setting flow rate, pipe diameter, supply pressure, and a response speed of a selected apparatus. This pressure dampening tank 12 dampens the interaction between the unillustrated valve of the mass flow controller 3a and the pressure adjusting valve 11, and hence the flow rate accuracy of the diluent gas is further improved.

The first communicating tube 13 is a tube into which either the diluent gas or the diluent gas and fluorine gas sucked by the ejector 4 and having passed through the mixer passes through, and this tube 13 is branched from the second communicating tube 16. Furthermore, at a non-edge part of the first communicating tube 13, a back pressure valve 14 is provided. On the downstream of the back pressure valve 14, a gas discharge valve 15 is further provided. In the first communicating tube 13, the downstream of the gas discharge valve 15 is connected to the harm removal apparatus 7.

The back pressure valve 14 keeps the pressure of fluid passing through the valve (fluid before passing through the valve) to be constant. The gas whose pressure is adjusted by the back pressure valve 14 passes through the gas discharge valve 15 and reaches the harm removal apparatus 7. The diluent gas and/or fluorine gas sucked by the ejector 4 and having passed through the mixer 5 is adjusted by the back pressure valve 14 to have a constant pressure. The setting pressure value of the back pressure valve 14 is preferably arranged to be equal to a pressure stability value on the downstream of the ejector 4 measured in advance, when the diluent gas whose flow rate is set by the mass flow controller 3a is introduced into the reactor 6. By setting this pressure value, it is possible to supply the mixed gas to the reactor 6 while keeping the flow rate and density of the mixed gas to be constant, right after the start of the supply. More preferably, the setting pressure value is arranged to be equal to a pressure stability value on the downstream of the ejector 4 measured in advance, when the mixed gas is introduced into the reactor 6. This setting further improves the control accuracy of the flow rate and density.

Since the flow rate of the fluorine gas supplied from the fluorine gas supplier 2 is low, the back pressure valve 14 predominantly adjusts the pressure of the diluent gas. For this reason, the back pressure valve 14 may be provided on a pipe upstream of the mixer 5. For example, the back pressure valve 14 may be provided on a pipe connecting the heater 8 with the ejector 4 or on a pipe connecting the ejector 4 with the mixer 5.

The gas discharge valve 15 is kept open until the flow rate of the diluent gas is stabilized. This valve is closed when the flow rate of the diluent gas is stabilized. This is because, since a driving pressure difference is required for generating a sufficient vacuum in the ejector 4 and a pressure increase toward the driving pressure difference gradually proceeds immediately after the supply of the diluent gas, it takes time to achieve stabilization of the flow rate of the diluent gas. Since the pressure of the fluorine gas does not greatly change in the fluorine gas supplier 2, the flow rate is promptly stabilized after the start of the supply. When the gas discharge valve 15 is opened, the diluent gas and/or mixed gas is introduced into the harm removal apparatus 7. On the other hand, when the gas discharge valve 15 is closed, the diluent gas and/or mixed gas is introduced into the reactor 6 via the second communicating tube 16.

The second communicating tube 16 introduces the diluent gas and fluorine gas into the reactor 6 after the flow rate of the diluent gas is stabilized.

The gas introducing valve 17 is opened after the flow rate of the diluent gas is stabilized and a sufficient vacuum is obtained, i. e. is opened at the same time as the gas discharge valve 15 is closed. The valve 17 is closed until the flow rate of the diluent gas is stabilized.

The gas discharge valve 15 and the gas introducing valve 17 are arranged so that, when the flow rate of the diluent gas is stabilized and the ejector 4 becomes a sufficient vacuum state, promptly the gas discharge valve 15 is closed and the gas introducing valve 17 is opened, and hence the path of the diluent gas and fluorine gas is switched from the first communicating tube 13 to the second communicating tube 16 and the gases are introduced into the reactor 6. Since the switching between the gas discharge valve 15 and the gas introducing valve 17 is promptly done, the flow rate and the vacuum state of the diluent gas and fluorine gas are rarely disturbed. Since the pressure in the fluorine gas supplier 2 does not change so much, the flow rate of the fluorine gas is promptly stabilized after the start of the supply. It is therefore preferable to start the supply of the fluorine gas at the same time as the switching between the gas discharge valve 15 and the gas introducing valve 17. In this case, the back pressure valve 14 preferably has a value which is equal to a pressure stability value on the downstream of the ejector 4 measured in advance, when the diluent gas whose flow rate is set by the mass flow controller 3a is introduced into the reactor 6. Alternatively, it is possible to adopt an arrangement such that, only the diluent gas is supplied first and then the fluorine gas is supplied before the switching between the gas discharge valve 15 and the gas introducing valve 17, the mixed gas whose flow rate and density are kept to be constant is discharged from the first communicating tube 13, and then the gas discharge valve 15 is closed whereas the gas introducing valve 17 is opened. This arrangement makes it possible to supply, to the reactor 6, the mixed gas whose flow rate and density are highly precisely controlled. In this case, the pressure value of the back pressure valve 14 is preferably equal to the pressure stability value on the downstream of the ejector 4 measured in advance, when the mixed gas having a determined flow rate is introduced into the reactor 6.

Now, the operation of the surface treatment apparatus 100 will be described. The diluent gas supplied from the diluent gas supplier 1 passes through the pressure adjusting valve 11 and is introduced into the pressure dampening tank 12, when the pressure adjusting valve 11 is opened. A part of the diluent gas is stored in the pressure dampening tank 12, whereas the remaining part of the diluent gas is introduced into the mass flow controller 3a via the pressure gauge 9. From the mass flow controller 3a, the diluent gas whose mass flow is controlled and flow rate is adjusted is introduced into the heater 8 via the pressure gauge 10.

When the pressure adjusting valve 11 is opened, a pressure difference between the pressure gauge 9 upstream of the mass flow controller 3a and the pressure gauge 10 downstream of the controller 3a is small, i.e. the driving pressure difference of the mass flow controller 3a is not achieved. In the meanwhile, when the pressure adjusting valve 11 is closed, the diluent gas supplied from the diluent gas supplier 1 is blocked by the pressure adjusting valve 11, and hence the diluent gas is not introduced into the pressure dampening tank 12. When the pressure adjusting valve 11 is closed, a pressure difference between the pressure gauge 9 upstream of the mass flow controller 3a and the pressure gauge 10 downstream of the controller 3a is large, i.e. the driving pressure difference of the mass flow controller 3a has been achieved. In this case, the diluent gas stored in the pressure dampening tank 12 is introduced into the mass flow controller 3a.

In the meanwhile, from the fluorine gas supplier 2, the fluorine gas is sucked by the ejector 4 via the mass flow controller 3b, as the diluent gas functions as a drive source. In the same manner as the diluent gas, the flow rate of the fluorine gas is controlled by the mass flow controller 3b, and the diluent gas whose flow rate has been adjusted is sucked by the ejector 4. The diluent gas and fluorine gas heated by the heater 8 are introduced into and mixed in the mixer 5, with the result that a mixed gas of the diluent gas and the fluorine gas is generated.

Thereafter, the mixed gas is introduced into the second communicating tube 16. Until the flow rate of the diluent gas is stabilized, the gas introducing valve 17 is closed whereas the gas discharge valve 15 is opened, and hence the diluent gas and/or fluorine gas is led into the first communicating tube 13. The diluent gas and/or fluorine gas led into the first communicating tube 13 is adjusted in its pressure by the back pressure valve 14, and then introduced into the harm removal apparatus 7 via the gas discharge valve 15.

Thereafter, when the flow rate of the diluent gas is stabilized and the ejector 4 achieves a sufficient vacuum state, promptly the gas discharge valve 15 is closed and the gas introducing valve 17 is opened, and the diluent gas and fluorine gas is switched to the first communicating tube 13 and introduced into the reactor 6 via the second communicating tube 16.

In the reactor 6, a treatment target 21 (indicated by a dotted line in Fig. 2) heated in advance by the heating chamber 23 has been transported by the movable member 22. The mixed gas supplied from the mixed gas supply opening 18 collides the plate member 20 in the reactor 6 so as to contact the treatment target 21, and hence the surface treatment and surface modification are carried out. Thereafter, after a predetermined processing time elapses, the gas in the reactor 6 is ejected through the mixed gas ejection opening 19 and introduced into the harm removal apparatus 7. After the fluorine gas and hydrogen fluoride gas are removed by the harm removal apparatus 7, the resultant gas is exhausted to the outside of the surface treatment apparatus 100.

According to the present embodiment, before the diluent gas is mixed with the fluorine gas, the diluent gas is heated in advance by the heater 8 and hence the heated diluent gas is mixed with the fluorine gas. This prevents the fluorine gas from being excessively heated, thereby restraining damages caused by the fluorine gas, such as corrosion of components of the surface treatment apparatus 100. Furthermore, since the heated mixed gas is supplied to the reactor 6, it is possible to restrain the occurrence of treatment irregularities of the treatment target 21.

In addition to the above, the ejector 4 can suck the fluorine gas from the fluorine gas supplier 2 by using the diluent gas as a drive source. Since this makes it possible to lower the supply pressure of the fluorine gas, it becomes unnecessary to store the fluorine gas with a high pressure, and hence the fluorine gas can be safely stored and used. Furthermore, the fluorine gas whose amount of supply is smaller than the diluent gas is accurately supplied in terms of amount.

Furthermore, since a constant driving pressure difference is applied to the mass flow controller 3a by the pressure adjusting valve 11, it is possible to supply the diluent gas at a constant flow rate, irrespective of influences of the pipes downstream of the diluent gas supplier 1 and the mass flow controller 3a and pressures such as the internal pressure of the reactor 6. Moreover, the pressure dampening tank 12 dampens the interaction between the pressure adjusting valve 11 and the unillustrated valve of the mass flow controller 3a, so as to further improve the accuracy of the flow rate. Also, the mass flow controller 3a makes it possible to precisely and stably control the gas flow rate without being influenced by temperatures and supply pressure.

In addition to the above, since the mass flow controller 3b makes it possible to precisely control the mass flow of the fluorine gas by an electric signal, the flow rate of the fluorine gas is precisely and stably controlled without being influenced by temperatures and supply pressure.

Furthermore, until the driving pressure difference for generating a sufficient vacuum in the ejector 4 is generated and the flow rate of the diluent gas is stabilized, the gas introducing valve 17 is closed and the gas discharge valve 15 is opened, and the diluent gas and/or fluorine gas is discharged to the harm removal apparatus 7 or the like via the first communicating tube 13. After the flow rate of the diluent gas is stabilized, the gas discharge valve 15 is closed and the gas introducing valve 17 is opened, so that the mixed gas is introduced into the reactor 6 via the second communicating tube 16. As a result, it is possible to supply to the reactor 6 a mixed gas whose flow rate and density are adjusted to be constant, right after the start of the supply.

Furthermore, since the treatment target 21 is heated in advance in the heating chamber 23 before contacting the mixed gas, it is possible to restrain treatment irregularities and improper treatments. Also, since the treatment target 21 is heated in advance, the time required for heating the treatment target 21 in the reactor 6 is shortened, with the result that cost reduction is achieved and the treatment efficiency is further improved.

In addition to the above, since the movable member 22 is made of a metal material having fluorine gas corrosion resistance, the treatment target 21 is easily transported into and from the reactor 6, and prevents the fluorine gas included in the mixed gas from generating impurities from the movable member 22.

Furthermore, since the plate member 20 is provided between the treatment target 21 and the mixed gas supplied to the reactor 6, the mixed gas hardly contacts the treatment target 21 directly around the mixed gas introducing part of the reactor 6, with the result that treatment irregularities of the treatment target 21 are restrained and the treatment target 21 is uniformly treated.

### <Second Embodiment>

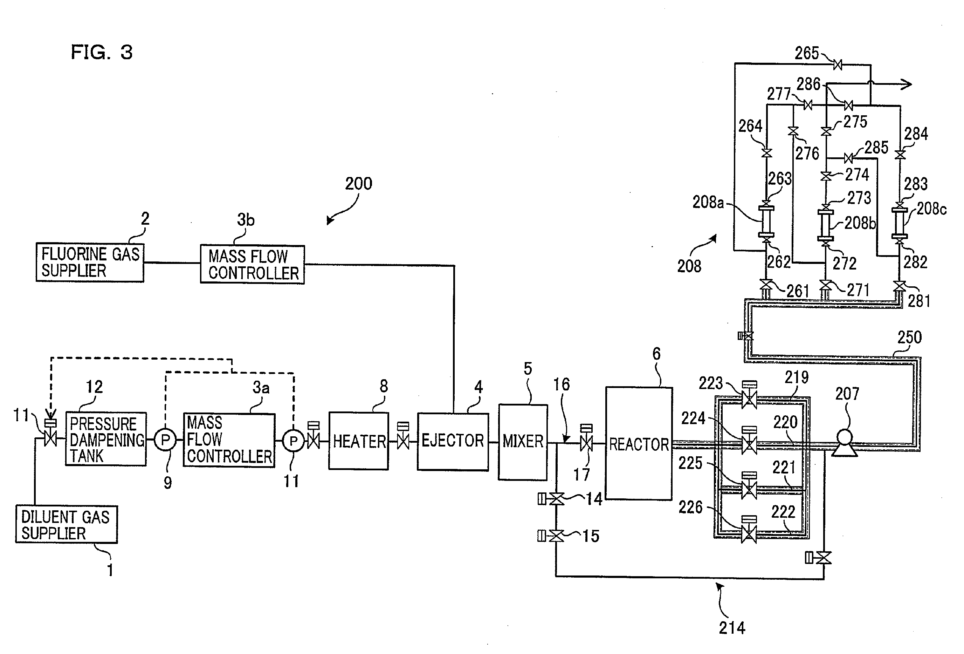

The following will describe a surface treatment apparatus according to Second Embodiment of the present invention. Fig. 3 outlines an essential part of the surface treatment apparatus according to Second Embodiment. It is noted that components having the same reference numerals as those of First Embodiment may not be described in this embodiment because such components are substantially identical with those of First Embodiment.

As shown in Fig. 3, a surface treatment apparatus 200 includes a diluent gas supplier 1, a fluorine gas supplier 2, a mass flow controller (first flow control unit) 3a which is connected to the diluent gas supplier 1 by a pipe, a mass flow controller (second flow control unit) 3b which is connected to the fluorine gas supplier 2 via a pipe, an ejector 4 connected to the mass flow controllers 3a and 3b by pipes, a mixer 5 which is connected to the ejector 4 by a pipe and is provided downstream of the ejector 4, a reactor 6 which treats a treatment target by a mixed gas supplied from the mixer 5, an exhauster 207 which exhausts a gas from the reactor 6, and a harm removal apparatus 208 which removes a fluorine gas and a hydrogen fluoride gas included in the gas exhausted from the reactor 6, and in this apparatus a heater (heating unit) 8 is provided between the mass flow controller 3a and the ejector 4. On the upstream and downstream of the mass flow controller 3a, pressure gauges 9 and 10 are provided, respectively. Further upstream of the pressure gauge 9, a pressure adjusting valve 11 and a pressure dampening tank 12 are provided. The surface treatment apparatus 100 further includes a second communicating tube 16 connected to the mixer 5 and the reactor 6, a gas introducing valve 17 provided at a non-edge portion of the second communicating tube 16, a first communicating tube 214 branching from a non-edge portion of the second communicating tube 16, and a back pressure valve 14 and a gas discharge valve 15 which are provided at non-edge portions of the first communicating tube 214. Furthermore, between the reactor 6 and the exhauster 207, four flow paths 219, 220, 221, and 222 and valves 223, 224, 225, and 226 on non-edge portions of the flow paths are provided. The pipes and components provided between the outlet of the reactor 6 to the inlet of the harm removal apparatus 208 are provided with heating/heat-retaining apparatuses 250, and hence the internal temperature of each of these pipes and components is maintained to be equal to or higher than the boiling temperature of the hydrogen fluoride.

The diluent gas supplier 1 supplies gas such as inert gas, by which fluorine gas is diluted. Non-limiting examples of diluent gas include nitrogen gas, oxygen gas, and argon gas.

The fluorine gas supplier 2 supplies fluorine gas. Examples of this fluorine gas supplier include an apparatus which generates a fluorine gas by supplying hydrogen fluoride from an unillustrated hydrogen fluoride supplier and electrolyzing the hydrogen fluoride, and a gas cylinder.

The mass flow controllers (first flow control unit and second flow control unit) 3a and 3b precisely control gas mass flow by means of electric signals. These apparatuses make it possible to precisely and stably control the flow of diluent gas and fluorine gas without being influenced by temperatures and supply pressures. In the mass flow controllers 3a and 3b, a gas pressure difference between the inlet and outlet must be in the range of 0.05-0.10MPa to achieve the flow control. Without this pressure difference, it is impossible to precisely conduct the flow control on account of pressure loss inside the mass flow controllers 3a and 3b. In this regard, a diluent gas and a fluorine gas are not properly supplied via the mass flow controllers 3a and 3b, when the inlet pressure is not lower than a pressure calculated by adding the treatment pressure (e.g. atmospheric pressure) of the reactor 6 downstream of the mass flow controllers 3a and 3b, a pressure loss (e.g. 0.05-0.10MPa) in the mass flow controllers 3a and 3b, and a pressure difference(e.g. 0.05-0.10MPa) required to push out required amounts of diluent gas and fluorine gas from the sources which are diluent gas supplier 1 and fluorine gas supplier 2. The inlet pressure above is, for example, higher than the atmospheric pressure by 0.10-0.20MPa. In connection with this, a combination of the ejector 4 and the mass flow controllers 3a and 3b makes it possible to lower the outlet pressure of the mass flow controllers 3a and 3b by the suction power of the ejector 4, and hence (because the pressure of the reactor 6 is negligible in this case) the pressure required for driving the inlets of the mass flow controllers 3a and 3b is reduced. On this account, the pressure for retaining and supplying the fluorine gas is lowered as much as the capability of the ejector. Since the fluorine gas is highly reactive, the danger of corrosion and gas leakage is restrained when the retaining pressure is lowered.

The ejector 4 sucks gas by creating a decompressed state by increasing the flow rate. This component makes it possible to surely suck a fluorine gas by using a diluent gas as a drive source. The sucked gas is introduced into the mixer 5. In place of the ejector 4, a vacuum generator may be used, for example. With this ejector 4, the upper limit of the pressure of the fluorine gas supplier 2 with which the fluorine gas is suitably supplied is 200kPa, and the lower limit is -65kPa(G).

The mixer 5 mixes the diluent gas and the fluorine gas sucked by the ejector 4, and introduces the mixed gas to the reactor 6. Alternatively, the mixed gas may be generated such that the ejector 4 sucks the fluorine gas by using the diluent gas as a drive source.

The reactor 6 receives the mixed gas of diluent gas and fluorine gas to perform surface treatment and surface modification of the treatment target. More specifically, as shown in Fig. 2, the reactor 6 has a mixed gas supply opening 18 and a mixed gas ejection opening 19, and inside the reactor 6 are provided a plate member 20, a treatment target 21, and a movable member 22. Along with the reactor 6, a heating chamber 23 is also provided.

The plate member 20 is arranged in a standing manner in the reactor 6 to block the supplied gas, between the mixed gas supply opening 18 and the treatment target 21. This plate member 20 may be provided on the movable member 22 or may be detachable. The plate member 20 restrains the mixed gas to directly contact the treatment target 21 around the mixed gas supply opening 18 of the reactor 6, thereby restraining the treatment irregularities and improper treatments.

The movable member 22 is capable of moving the treatment target 21 to the inside or outside of the reactor 6, and is preferably made of a metal material having fluorine gas corrosion resistance, e.g. a mesh or punched metal made of stainless steel or the like. The movable member 22 is provided with wheels; alternatively, no wheels may be attached. As another modification, the metal components may be a mesh or punched metal, a metal frame, and wheels.

The heating chamber 23 is provided for heating the treatment target 21 in advance before causing the treatment target 21 to contact the mixed gas. The parts indicated by the dotted lines in Fig. 2 are the treatment target 21 being heated in the heating chamber 23 and the movable member 22 capable of moving the treatment target 21 to the reactor 6. Since it is preferable that the treatment target 21 contacts the mixed gas and is treated while being heated, the treatment target 21 is preferably transferred from the heating chamber 23 to the reactor 6 quickly. The heating chamber 23 is therefore preferably provided around the reactor 6, and the heating chamber 23 may be connected to the reactor 6. As modifications, the heating chamber 23 may be adjacent to the reactor 6, and the heating chamber 23 may be provided in the reactor 6.

The exhauster 207 exhausts the gas inside the reactor 6 and introduces the gas into the harm removal apparatus 208 after the surface treatment, surface modification or the like finishes in the reactor 6, and has a pump. Since the surface treatment and surface modification using a fluorine gas generate hydrogen fluoride from the surface of the treatment target 21, the gas exhausted from the reactor 6 includes a fluorine gas and a hydrogen fluoride gas.

The harm removal apparatus 208 detoxifies the gas exhausted from the reactor 6 by removing hydrogen fluoride gas and fluorine gas generated from the surface of the treatment target 21 as a result of the surface treatment by the reactor 6. This harm removal apparatus 208 has three harm removal towers 208a, 208b, and 208c. the harm removal towers 208a, 208b, and 208c are filed with a harm removal agent. Examples of this harm removal agent include an agent mainly made of sodium fluoride absorbing hydrogen fluoride gas and soda lime absorbing fluorine gas and hydrogen fluoride gas.

In the harm removal apparatus 208, one of the harm removal towers 208a, 208b, and 208c is independently connected to the remaining towers whereas the remaining two towers are connected in series with each other, by switching valves. When the surface treatment apparatus 200 operates, one tower among the two harm removal towers connected in series is used, and the other harm removal tower is additionally connected to the one tower to supplement the one tower by subsequently removing the fluorine gas and hydrogen fluoride gas that the one tower cannot be removed. On the other hand, the independent tower is in maintenance or in the state in which a harm removal agent is being replaced, for example. The connection is established by switching (opening and closing) the valves. Which one of the harm removal towers is selected as the independent tower or as one of the other two towers is suitably determined in accordance with the state of use of the harm removal agent.

The following will describe an example of how the three harm removal towers 208a, 208b, and 208c are used. The harm removal tower 208a is connected to be independent from the two harm removal towers 208b and 208c, so that its maintenance, replacement of the harm removal agent or the like is conducted. The two harm removal towers 208b and 208c are connected in series with each other, so that the fluorine gas and the hydrogen fluoride gas included in the gas exhausted from the reactor 6 are removed by the harm removal towers 208a and 208b. In this case, valves 261, 262, 263, 264, 265, 275, 276, 277, and 281 are closed, whereas valves 271, 272, 273, 274, 282, 283, 284, 285, and 286 are opened.

Thereafter, the harm removal tower 208b is connected to be independent from the two harm removal towers 208a and 208c, so that its maintenance, replacement of the harm removal agent or the like is conducted. The two harm removal towers 208a and 208c are connected in series with each other, so that the fluorine gas and the hydrogen fluoride gas included in the gas exhausted from the reactor 6 are removed by the harm removal towers 208a and 208c. In this case, the valves 261, 272, 273, 274, 277, 281, and 286 are closed, whereas the valves 262, 263, 264, 265, 271, 275, 276, 282, 283, and 284 are opened.

Thereafter, the harm removal tower 208c is connected to be independent from the two harm removal towers 208a and 208b, so that its maintenance, replacement of the harm removal agent or the like is conducted. The two harm removal towers 208a and 208b are connected in series with each other, so that the fluorine gas and the hydrogen fluoride gas included in the gas exhausted from the reactor 6 are removed by the harm removal towers 208a and 208b. In this case, the valves 265, 271, 277, 281, 282, 283, 284, 285, and 286 are closed, whereas the valves 261, 262, 263, 264, 272, 273, 274, 275, and 276 are opened.

The fluorine gas and hydrogen fluoride gas removed by the harm removal apparatus 208 are exhausted to the outside of the surface treatment apparatus 200. Alternatively, these types of gases may be used for the surface treatment again. The number of the harm removal towers is not limited to three, and hence the number of the towers may be four or more.

The heater (heating unit) 8 heats the diluent gas supplied from the diluent gas supplier 1, before the gas is mixed with the fluorine gas, and is provided at a non-edge part of the pipe connecting the ejector 4 with the pressure gauge 10. An example of the heater (heating unit) 8 is a heater.

The pressure gauge 9 measures a pressure on the upstream of the mass flow controller 3a, and is provided on the upstream of the mass flow controller 3a. The pressure gauge 10 measures a pressure on the downstream of the mass flow controller 3a, and is provided on the downstream of the mass flow controller 3a.

The pressure adjusting valve 11 puts a constant driving pressure difference to the mass flow controller 3a in accordance with a difference between the pressure of the pressure gauge 9 and the pressure of the pressure gauge 10. The pressure adjusting valve 11 is provided between the diluent gas supplier 1 and the pressure dampening tank 12 and connected with them by a pipe. With this arrangement, the pressure adjusting valve 11 is capable of supplying the diluent gas with a pressure higher than the sum of the maximum pressure on the downstream side of the ejector 4, the driving pressure difference of the ejector 4, the driving pressure difference of the mass flow controller 3a, and the pressure loss in each of the components constituting the surface treatment apparatus 100. In addition to the above, when the supply of the diluent gas is fixed by the mass flow controller 3a, no pressure difference is generated on the upstream side and the downstream side of the ejector 4, and a pressure is generated only when the diluent gas is supplied. On this account, the pressure differences on the upstream and downstream of the mass flow controller 3a before the supply of the diluent gas often exceed the driving pressure difference, with the result that a valve (not illustrated) of the mass flow controller 3a is closed and the supply of the diluent gas may be impossible. In such a case, it is possible to supply the diluent gas in such a way that the flow rate of the diluent gas is adjusted by the pressure adjusting valve 11 to put a constant driving pressure difference to the upstream and downstream of the mass flow controller 3a.

Now, valve hunting occurring in the valve of the mass flow controller 3a and the pressure adjusting valve 11 will be detailed. When the flow rate of the diluent gas is low, the valve of the mass flow controller 3a is opened so that the flow rate increases whereas the driving pressure difference decreases. As a result of this, the pressure adjusting valve 11 is opened to secure the pressure and hence the pressure increases, whereas the flow rate of the diluent gas exceeds a setting value and hence the valve (not illustrated) of the mass flow controller 3a is closed. Consequently, the driving pressure difference increases and the pressure adjusting valve 11 is closed, and hence the driving pressure difference decreases and the flow rate of the diluent gas also decreases.

The pressure dampening tank 12 is provided between the pressure adjusting valve 11 and the pressure gauge 9 via a pipe, and is capable of storing the diluent gas supplied from the diluent gas supplier 1. This pressure dampening tank 12 makes it possible to prevent the flow rate accuracy of the diluent gas from being lowered when the hunting of the unillustrated valve of the mass flow controller 3a and the pressure adjusting valve 11 occurs due to, for example, a combination of a setting flow rate, pipe diameter, supply pressure, and a response speed of a selected apparatus. This pressure dampening tank 12 dampens the interaction between the unillustrated valve of the mass flow controller 3a and the pressure adjusting valve 11, and hence the flow rate accuracy of the diluent gas is further improved.

The first communicating tube 214 is a tube into which either the diluent gas or the diluent gas and fluorine gas sucked by the ejector 4 and having passed through the mixer passes through, and this tube 214 is branched from the second communicating tube 16. Furthermore, at a non-edge part of the first communicating tube 214, a back pressure valve 14 is provided. On the downstream of the back pressure valve 14, a gas discharge valve 15 is further provided. In the first communicating tube 214, the further downstream side of the gas discharge valve 15 is connected to the exhauster 207 and the harm removal apparatus 208.

The back pressure valve 14 keeps the pressure of fluid passing through the valve to be constant. The gas whose pressure is adjusted by the back pressure valve 14 passes through the gas discharge valve 15 and reaches the harm removal apparatus 208. The diluent gas and/or fluorine gas sucked by the ejector 4 and having passed through the mixer 5 is adjusted by the back pressure valve 14 to have a constant pressure. The setting pressure value of the back pressure valve 14 is preferably arranged to be equal to a pressure stability value on the downstream of the ejector 4 measured in advance, when the diluent gas whose flow rate is set by the mass flow controller 3a is introduced into the reactor 6. By setting this pressure value, it is possible to supply the mixed gas to the reactor 6 while keeping the flow rate and density of the mixed gas to be constant, right after the start of the supply. More preferably, the setting pressure value is arranged to be equal to a pressure stability value on the downstream of the ejector 4 measured in advance, when the mixed gas is introduced into the reactor 6. This setting further improves the control accuracy of the flow rate and density.

The gas discharge valve 15 is kept open until the flow rate of the diluent gas is stabilized. This valve is closed when the flow rate of the diluent gas is stabilized. This is because, since a driving pressure difference is required for generating a sufficient vacuum in the ejector 4 and a pressure increase toward the driving pressure difference gradually proceeds immediately after the supply of the diluent gas, it takes time to achieve stabilization of the flow rate of the diluent gas. Since the pressure of the fluorine gas does not greatly change in the fluorine gas supplier 2, the flow rate is promptly stabilized after the start of the supply. When the gas discharge valve 15 is opened, the diluent gas and/or mixed gas is introduced into the exhauster 207 via the first communicating tube 214. On the other hand, when the gas discharge valve 15 is closed, the diluent gas and/or mixed gas is introduced into the reactor 6 via the second communicating tube 16.

The second communicating tube 16 introduces the diluent gas and fluorine gas into the reactor 6 after the flow rate of the diluent gas is stabilized.

The gas introducing valve 17 is opened after the flow rate of the diluent gas is stabilized and a sufficient vacuum is obtained, i.e. is opened at the same time as the gas discharge valve 15 is closed. The valve 17 is closed until the flow rate of the diluent gas is stabilized.

The gas discharge valve 15 and the gas introducing valve 17 are arranged so that, when the flow rate of the diluent gas is stabilized and the ejector 4 becomes a sufficient vacuum state, promptly the gas discharge valve 15 is closed and the gas introducing valve 17 is opened, and hence the path of the diluent gas and fluorine gas is switched from the first communicating tube 214 to the second communicating tube 16 and the gases are introduced into the reactor 6. Since the switching between the gas discharge valve 15 and the gas introducing valve 17 is promptly done, the flow rate and the vacuum state of the diluent gas and fluorine gas are rarely disturbed. Since the pressure in the fluorine gas supplier 2 does not change so much, the flow rate of the fluorine gas is promptly stabilized after the start of the supply. It is therefore preferable to start the supply of the fluorine gas at the same time as the switching between the gas discharge valve 15 and the gas introducing valve 17. In this case, the back pressure valve 14 preferably has a value which is equal to a pressure stability value on the downstream of the ejector 4 measured in advance, when the diluent gas whose flow rate is set by the mass flow controller 3a is introduced into the reactor 6. Alternatively, it is possible to adopt an arrangement such that, only the diluent gas is supplied first and then the fluorine gas is supplied before the switching between the gas discharge valve 15 and the gas introducing valve 17, the mixed gas whose flow rate and density are kept to be constant is discharged from the first communicating tube 214, and then the gas discharge valve 15 is closed whereas the gas introducing valve 17 is opened. This arrangement makes it possible to supply, to the reactor 6, the mixed gas whose flow rate and density are highly precisely controlled. In this case, the pressure value of the back pressure valve 14 is preferably equal to the pressure stability value on the downstream of the ejector 4 measured in advance, when the mixed gas having a determined flow rate is introduced into the reactor 6.

The flow paths 219, 220, 221, and 222 are provided between the reactor 6 and the exhauster 207 in a branching manner, and through these flow paths exhaust gas from the reactor 6 passes. The flow paths 219, 220, 221, and 222 may have different diameters, or at least two of or all of the flow paths may have the same diameter. When the flow paths have different diameters, a flow path having a small diameter is used first, and this flow path is replaced one by one with other flow paths having larger diameters, as the gas exhausting proceeds. When at least two of or all of the flow paths have the same diameter, only one flow path is used first, and then the number of flow paths used is gradually increased as the gas exhausting proceeds. Although there are four flow paths 219, 220, 221, and 222 in the case above, the number of flow paths may be two, three, five, or more.

The valves 223, 224, 225, and 226 are provided at non-edge portions of the flow paths 219, 220, 221, and 222, respectively. The valves 223, 224, 225, and 226 may be automatic valves, manual valves, or other types of valves.

Now, an example of the gas exhausted from the mixed gas ejection opening 19 of the reactor 6 shown in Fig. 2 will be detailed. In the flow paths 219, 220, 221, and 222 having different diameters (the flow paths 219, 220, 221, and 222 are numbered in the order of increase in the diameter), the valve 223 on the flow path 219 whose diameter is the smallest is opened among the valve 223, 224, 225, 226, whereas the remaining valves 224, 225, and 226 are closed. As a result, the gas passes through only the flow path 219, and hence the gas is introduced into the exhauster 207 at a low flow rate. Thereafter, the flow path is switched one by one to other flow paths having larger diameters, as the gas exhausting proceeds. That is to say, the valve 224 on the flow path 220 having the second smallest diameter is opened whereas the valve 223 is closed, so that the gas flow path is switched from the flow path 219 to the flow path 220. Alternatively, when the valve 224 is opened, the valve 223 is kept open so that both of the flow paths 219 and 220 are used, or only the valve 223 is opened and then the valve 224 after a while, so that the low paths are used as follows: only flow path 219 → only flow path 220→ both flow paths 219 and 220. Thereafter, in the same manner as above, the flow path is switched one by one to other flow paths having larger diameters, as the gas exhausting proceeds. That is to say, the valves 223 and 224 are closed whereas the valves 225 and 226 are serially opened, so that the gas flow path is serially switched to the flow paths 221 and 222. Alternatively, plural valves are opened so that the gas is allowed to pass through plural flow paths.

In another modification, the flow paths 219, 220, 221, and 222 having the same diameter are switched in such a way that, firstly one of the valves, e.g. the valve 223 is opened whereas the other valves 224, 225, and 226 are closed so that the gas is exhausted, and then the number of gas flow paths is changed from one to two, two to three, and three to four as the has exhausting proceeds. In other words, the number of gas flow paths is increased such that the valves 224, 225, and 226 are opened without closing the valve 223 which has already been opened. Also when, for example, two flow paths have the same diameter whereas the remaining two flow paths have the same diameter or when two flow paths have the same diameter but the remaining two flow paths have different diameters, it is possible to switch the gas flow paths in a similar manner as above as the gas exhausting proceeds.

From the outlet of the reactor 6 to the inlet of the harm removal apparatus 208, each of the pipes and components, particularly each of the metal parts constituting the pipes and components is provided with a heating/heat-retaining apparatus 250, and hence the internal temperature of each of the pipes and components is kept to be not lower than the boiling temperature of hydrogen fluoride, i.e. not lower than about 19 degrees centigrade. An example of the heating device is a heater. An example of the heat-retaining material (heat-retaining apparatus) is a heat-insulating material. As an alternative to the present embodiment in which the heating/heat-retaining apparatus 250 is attached to a pipe, the heating/heat-retaining apparatus 250 is preferably attached to each of the valves 223, 224, 225, and 226 and exhauster 207.

Now, the operation of the surface treatment apparatus 100 will be described. The diluent gas supplied from the diluent gas supplier 1 passes through the pressure adjusting valve 11 and is introduced into the pressure dampening tank 12, when the pressure adjusting valve 11 is opened. A part of the diluent gas is stored in the pressure dampening tank 12, whereas the remaining part of the diluent gas is introduced into the mass flow controller 3a via the pressure gauge 9. From the mass flow controller 3a, the diluent gas whose mass flow is controlled and flow rate is adjusted is introduced into the heater 8 via the pressure gauge 10.

When the pressure adjusting valve 11 is opened, a pressure difference between the pressure gauge 9 upstream of the mass flow controller 3a and the pressure gauge 10 downstream of the controller 3a is small, i.e. the driving pressure difference of the mass flow controller 3a is not achieved. In the meanwhile, when the pressure adjusting valve 11 is closed, the diluent gas supplied from the diluent gas supplier 1 is blocked by the pressure adjusting valve 11, and hence the diluent gas is not introduced into the pressure dampening tank 12. When the pressure adjusting valve 11 is closed, a pressure difference between the pressure gauge 9 upstream of the mass flow controller 3a and the pressure gauge 10 downstream of the controller 3a is large, i.e. the driving pressure difference of the mass flow controller 3a has been achieved. In this case, the diluent gas stored in the pressure dampening tank 12 is introduced into the mass flow controller 3a.

In the meanwhile, from the fluorine gas supplier 2, the fluorine gas is sucked by the ejector 4 via the mass flow controller 3b, as the diluent gas functions as a drive source. In the same manner as the diluent gas, the flow rate of the fluorine gas is controlled by the mass flow controller 3b, and the diluent gas whose flow rate has been adjusted is sucked by the ej ector 4. The diluent gas and fluorine gas are introduced into and mixed in the mixer 5, with the result that a mixed gas of the diluent gas and the fluorine gas is generated.

Thereafter, the mixed gas is introduced into the second communicating tube 16. Until the flow rate of the diluent gas is stabilized, the gas introducing valve 17 is closed whereas the gas discharge valve 15 is opened, and hence the diluent gas and/or fluorine gas is led into the first communicating tube 214. The diluent gas and/or fluorine gas led into the first communicating tube 214 is adjusted in its pressure by the back pressure valve 14, and then introduced into the exhauster 207 via the gas discharge valve 15.

Thereafter, when the flow rate of the diluent gas is stabilized and the ejector 4 achieves a sufficient vacuum state, promptly the gas discharge valve 15 is closed and the gas introducing valve 17 is opened, and the diluent gas and fluorine gas is switched to the first communicating tube 214 and introduced into the reactor 6 via the second communicating tube 16.

In the reactor 6, a treatment target 21 (indicated by a dotted line in Fig. 2) heated in advance by the heating chamber 23 has been transported by the movable member 22. The mixed gas supplied from the mixed gas supply opening 18 collides the plate member 20 in the reactor 6 so as to contact the treatment target 21, and hence the surface treatment and surface modification are carried out. Thereafter, after a predetermined processing time elapses, the gas in the reactor 6 is ejected through the mixed gas ejection opening 19 by the exhauster 207.

The gas exhausted from the mixed gas ejection opening 19 passes through at least one of the flow paths 219, 220, 221, and 222 and reaches the exhauster 207. As an example of the gas exhausted from the mixed gas ejection opening 19, firstly, the valve 223 is opened whereas the valves 224, 225, and 226 are closed, so that the gas is introduced into the exhauster 207 only via the flow path 219. Thereafter, as the gas exhausting proceeds, gradually other valves are opened and/or the number of opened valves is increased, so that the gas flow path is switched from a flow path with a smaller diameter to a flow path with a large diameter and/or the number of used flow paths is increased. As such, after passing through the valves 223, 224, 225, and 226 and the flow paths 219, 220, 221, and 222, the gas passes through the exhauster 207 and reaches the harm removal apparatus 208.

Since each of the pipes and components from the outlet of the reactor 6 to the inlet of the harm removal apparatus 208 has a heating/heat-retaining unit, the fluorine gas and hydrogen fluoride gas included in the gas exhausted from the mixed gas ejection opening 19 are introduced into the harm removal apparatus 208 without being liquefied.

From the gas introduced into the harm removal apparatus 208, the fluorine gas and hydrogen fluoride gas are removed by the harm removal towers 208a, 208b, and 208c. Now, an example of the gas introduced into the harm removal apparatus 208 will be given. Regarding the harm removal towers 208b and 208c which are connected in series with each other by unillustrated valve and pipe, the gas introduced into the harm removal tower 208b is exhausted to the outside of the surface treatment apparatus 200 after the fluorine gas and hydrogen fluoride gas components are absorbed and removed therefrom by soda lime with which the harm removal tower 208b is filled. When the break through of the harm removal tower 208b is confirmed as a result of the detection of acidity in the gas exhausted from the outlet of the harm removal tower 208b, the gas is introduced into the harm removal tower 208c by pipes and unillustrated valves of the harm removal apparatus. In the harm removal tower 208c, the fluorine gas and hydrogen fluoride gas components are absorbed and removed by the soda lime with which the tower 208c is filled, and then the gas is exhausted to the outside of the surface treatment apparatus 200. The gas from which the fluorine gas and hydrogen fluoride gas have been removed may be used for the surface treatment again.

According to the present embodiment, before the diluent gas is mixed with the fluorine gas, the diluent gas is heated in advance by the heater 8, and then the heated diluent gas is mixed with the fluorine gas. Since the fluorine gas is indirectly heated by the diluent gas, the fluorine gas is unlikely to be excessively heated, and it is therefore possible to restrain damages such as corrosion of the surface treatment apparatus 200 by the fluorine gas. Furthermore, since the heated mixed gas is supplied to the reactor 6, it is possible to prevent the treatment irregularities of the treatment target 21.

In addition to the above, the ejector 4 can suck the fluorine gas from the fluorine gas supplier 2 by using the diluent gas as a drive source. Since this makes it possible to lower the supply pressure of the fluorine gas, it becomes unnecessary to store the fluorine gas with a high pressure, and hence the fluorine gas can be safely stored. Furthermore, the fluorine gas whose amount of supply is smaller than the diluent gas is accurately supplied in terms of amount.

Furthermore, since a constant driving pressure difference is applied to the mass flow controller 3a by the pressure adjusting valve 11, it is possible to supply the diluent gas at a constant flow rate, irrespective of influences of the pipes downstream of the diluent gas supplier 1 and the mass flow controller 3a and pressures such as the internal pressure of the reactor 6. Moreover, the pressure dampening tank 12 dampens the interaction between the pressure adjusting valve 11 and the unillustrated valve of the mass flow controller 3a, so as to further improve the accuracy of the flow rate. Also, the mass flow controller 3a makes it possible to precisely and stably control the gas flow rate without being influenced by temperatures and supply pressure.

In addition to the above, since the mass flow controller 3b makes it possible to precisely control the mass flow of the fluorine gas by an electric signal, the flow rate of the fluorine gas is precisely and stably controlled without being influenced by temperatures and supply pressure.

Furthermore, until the driving pressure difference for generating a sufficient vacuum in the ejector 4 is generated and the flow rate of the diluent gas is stabilized, the gas introducing valve 17 is closed and the gas discharge valve 15 is opened, and the diluent gas and/or fluorine gas is discharged to the exhauster 207 and the harm removal apparatus 208 or the like via the first communicating tube 214. After the flow rate of the diluent gas is stabilized, the gas discharge valve 15 is closed and the gas introducing valve 17 is opened, so that the mixed gas is introduced into the reactor 6 via the second communicating tube 16. As a result, it is possible to supply to the reactor 6 a mixed gas whose flow rate and density are adjusted to be constant, right after the start of the supply.

Furthermore, since the treatment target 21 is heated in advance in the heating chamber 23 before contacting the mixed gas, it is possible to restrain treatment irregularities and improper treatments. Also, since the treatment target 21 is heated in advance, the time required for heating the treatment target 21 in the reactor 6 is shortened, with the result that cost reduction is achieved and the treatment efficiency is further improved.

In addition to the above, since the movable member 22 is made of a metal material having fluorine gas corrosion resistance, the treatment target 21 is easily transported into or from the reactor 6, and prevents the fluorine gas included in the mixed gas from generating impurities from the movable member 22.

Furthermore, since the plate member 20 is provided between the treatment target 21 and the mixed gas supplied to the reactor 6, the mixed gas hardly contacts the treatment target 21 directly around the mixed gas introducing part of the reactor 6, with the result that treatment irregularities of the treatment target 21 are restrained and the treatment target 21 is uniformly treated.

In addition to the above, the valves 223, 224, 225, and 226 are suitably opened and closed, so that the gas is introduced into the exhauster 207 and the harm removal apparatus 208 at a desired flow rate by suitably replacing the flow paths 219, 220, 221, and 222 having different diameters with one another and/or changing the number of used flow paths. With this, even if a large amount of gas including fluorine gas is exhausted from the reactor 6, it is possible to prevent the large amount of gas to be introduced into the exhauster 207 and the harm removal apparatus 208 at once, by using the flow paths 219, 220, 221, and 222 and the valves 223, 224, 225, and 226, thereby preventing a problem of partial corrosion and rapid deterioration which occur because a large amount of fluorine gas increases the heat generation of the harm removal agent and hence the pipes, components, devices, harm removal agent and the like on the downstream of the reactor 6 are loaded. Furthermore, because the exhauster 207 is provided, it becomes easy to exhaust gas from the reactor 6. Furthermore, since the fluorine gas and hydrogen fluoride gas in the gas exhausted from the reactor 6 are removed by the harm removal apparatus 208 and the gas whose flow rate is adjusted and controlled to be a desired value is introduced into the harm removal apparatus 208, it is possible to consume and replace the harm removal agent filling the harm removal apparatus 208 efficiently and precisely, and hence the costs for replacing parts and components of the surface treatment apparatus 200 are further restrained. Because of the above, it is possible to prevent the apparatus from being damaged by the gas exhausting after the surface treatment.

When the hydrogen fluoride gas generated by the surface treatment and/or surface modification is mixed into the fluorine gas, the metal parts of the pipes and valves are corroded and/or deteriorated, and such corrosion and deterioration are facilitated when the hydrogen fluoride gas is liquefied. In this regard, since the internal temperatures of the pipes and components from the outlet of the reactor 6 to the inlet of the harm removal apparatus 208 are kept to be not lower than the boiling temperature of the hydrogen fluoride, it is possible to prevent the hydrogen fluoride gas in the gas exhausted from the reactor 6 from being liquefied. It is therefore possible to further restrain the corrosion and deterioration of the metal parts constituting the pipes and components or the like, and to introduce the fluorine gas and hydrogen fluoride gas to the harm removal apparatus 208 without the liquefaction thereof.

In addition to the above, in the harm removal apparatus 208, two harm removal towers 208b and 208c are connected in series with each other whereas the remaining one harm removal tower 208a is independently connected. It is therefore possible to perform replacement of the harm removal agent or maintenance of the one tower for future use while the two towers are continuously in use. Furthermore, since two harm removal towers 208b and 208c can be continuously in use, it is possible to keep the harm removal towers 208a, 208b, and 208c in a safe state while the operation of the surface treatment apparatus 200 is continued.

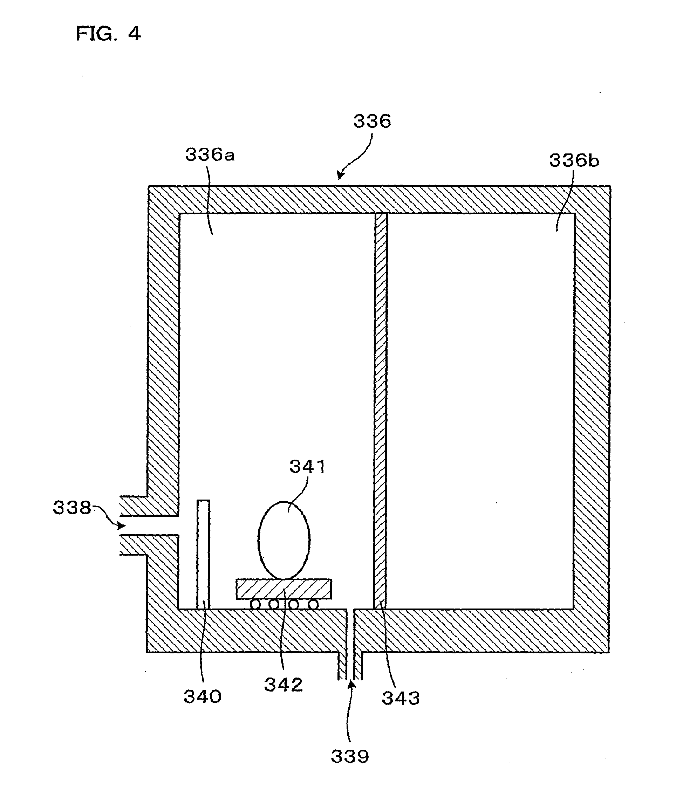

Now, a modification of the reactors used for surface treatment apparatus in First Embodiment and Second Embodiment will be described. Fig. 4 shows a modification of the reactor of Fig. 2.

As shown in Fig. 4, a reactor 336 further includes therein a plate member 343, and this plate member 343 forms two chambers, namely a reaction chamber 336a and a heating chamber 336b. It is noted that a mixed gas supply opening 338, a mixed gas ejection opening 339, a plate member 340, a treatment target 341, and a movable member 342 are identical with the mixed gas supply opening 18, the mixed gas ejection opening 19, the plate member 20, the treatment target 21, and the movable member 22 of the embodiments above, and the components assigned with reference numerals 18 to 22 in the embodiments above are identical with the components assigned with the reference numerals 338 to 342 of the modification, respectively. The descriptions of these components may therefore be omitted.

When the reactor 336 arranged as above is used in place of the reactor 6 and the heating chamber 23 of the surface treatment apparatuses 100 and 200, effects similar to those of the surface treatment apparatuses 100 and 200 are achieved. Furthermore, since the reaction chamber 336a is provided adjacent to the heating chamber 336b, it is possible to move the treatment target quickly to the reaction chamber 336a after the heating in the heating chamber 336b. When the plate member 343 is detachable, the reaction chamber 336a can be moved more easily. The plate member 343 may be detachable or may not be detachable. Also, for example, a closable opening may be provided to connect the reaction chamber 336a with the heating chamber 336b. This opening allows the treatment target 341 to move from the heating chamber 336b to the reaction chamber 336a therethrough.

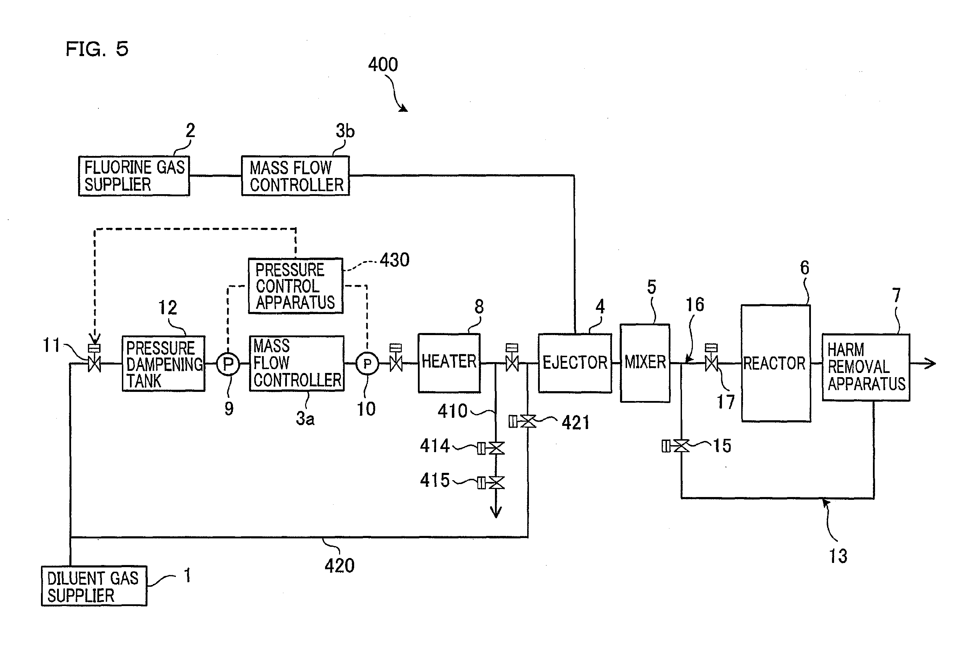

Now, a modification of the surface treatment apparatus of First Embodiment will be described. Fig. 5 outlines an essential part of a surface treatment apparatus of the modification. It is noted that the same reference numerals are assigned to components having substantially identical arrangements as those of First Embodiment and such components will not be described again.

The surface treatment apparatus 400 of the modification is further provided with a diluent gas discharging pipe 410 branched from the pipe connecting the heater 8 with the ejector 4. The apparatus 400 is also provided with a fluorine gas purging line 420 branched from the pipe connecting the diluent gas supplier 1 with the pressure adjusting tank 12. The downstream of the fluorine gas purging line 420 is connected to the pipe connecting the heater 8 with the ejector 4. In addition, the apparatus 400 is further provided with a pressure control apparatus (pressure control unit) 430 which controls the primary pressure on the mass flow controller 3a based on the pressures in the pipes measured by the pressure gauges 9 and 10. Moreover, in place of the back pressure valve 14 of First Embodiment, the diluent gas discharging pipe 410 is provided with a back pressure valve 414.

The diluent gas discharging pipe 410 is on the upstream of a valve on the pipe connecting the heater 8 with the ejector 4. From the upstream to the downstream, the diluent gas discharging pipe 410 is provided with a back pressure valve 414 and a diluent gas discharge valve 415 in this order. Being similar to the back pressure valve 14 of First Embodiment, the back pressure valve 414 keeps the pressure of the diluent gas before entering the back pressure valve 414 to be constant. This back pressure valve 414 preferably has, in the same manner as the back pressure valve 14 of First Embodiment, a pressure value equal to a pressure stability value on the downstream of the ejector 4 measured in advance, when the diluent gas whose flow rate is set by the mass flow controller 3a is introduced into the reactor 6 or equal to a pressure stability value on the downstream of the ejector 4 measured in advance, when the mixed gas whose flow rate is set is introduced into the reactor 6. Since this makes it possible to keep the flow rate and density of the diluent gas, which constitutes a large part of the mixed gas, to be constant, it is possible to supply to the reactor 6 mixed gas having the constant flow rate and density, right after the start of the supply. The diluent gas discharge valve 415 discharges the diluent gas, which has been introduced into the diluent gas discharging pipe 410 and has a pressure adjusted by the back pressure valve 14, to the downstream side of the diluent gas discharging pipe 410. The diluent gas discharging pipe 410 may be provided with an unillustrated temperature gauge. By using this temperature gauge, the temperature of diluent gas passing through the diluent gas discharging pipe 410 is measured so that the back pressure valve 414 and the diluent gas discharge valve 415 are opened and/or closed.

Until the diluent gas is sufficiently heated by the heater 8 to reach a predetermined temperature, the valve on the pipe connecting the heater 8 with the ejector 4 is closed whereas the back pressure valve 414 and the diluent gas discharge valve 415 are opened. The diluent gas which has not been sufficiently heated by the heater 8 is introduced into the diluent gas discharging pipe 410, and then discharged to the outside of the surface treatment apparatus 400 via the back pressure valve 414 and the diluent gas discharge valve 415. When it is confirmed that the diluent gas reaches the predetermined temperature as a result of measurement by an unillustrated temperature gauge, the back pressure valve 414 and the diluent gas discharge valve 415 are closed whereas the valve on the pipe connecting the heater 8 with the ejector 4 is opened. The diluent gas having reached the predetermined temperature passes through the ejector 4 and then reaches the mixer 5.

To cool the heater 8, it is possible to use the diluent gas discharging pipe 410, the back pressure valve 414, and the diluent gas discharge valve 415 in the same manner as above. The heater 8 is swiftly cooled in such a way that the valve on the pipe connecting the heater 8 with the ejector 4 is closed whereas the back pressure valve 414 and the diluent gas discharge valve 415 are opened so that the diluent gas is discharged from the diluent gas discharging pipe 410.

The downstream end of the diluent gas discharging pipe 410 may be connected, for example, to the diluent gas supplier 1 or the pipe connecting the diluent gas supplier 1 with the pressure dampening tank 12. This allows the diluent gas discharged from the diluent gas discharging pipe 410 to be used for diluting fluorine gas again or for cooling the heater.

The fluorine gas purging line 420 is connected to the upstream of the pressure adjusting valve 11 on the pipe connecting the diluent gas supplier 1 with the pressure adjusting tank 12. The downstream of the fluorine gas purging line 420 is connected to the downstream of the valve at a non-edge part of the pipe connecting the heater 8 with the ejector 4. The fluorine gas purging line 420 is provided with a valve, and a non-heated diluent gas supplied from the diluent gas supplier 1 passes through this valve. The diluent gas having passed through the fluorine gas purging line 420 is introduced into the ejector 4. To purge, by the diluent gas, the fluorine gas in the pipes and components downstream of the ejector 4, it is unnecessary to heat the diluent gas. In such a case, the fluorine gas in the pipes and components downstream of the ejector 4 is purged by using non-heated diluent gas having passed through the fluorine gas purging line 420.

To purge the fluorine gas in the pipes and components downstream of the ejector 4, the valve on the pipe connecting the heater 8 with the ejector 4 is closed whereas the valve on the fluorine gas purging line 420 is opened. As a result of this, non-heated diluent gas passes through the ejector 4 and is led toward the downstream along with the fluorine gas in the pipes and components downstream of the ejector 4.

The connection between the diluent gas supplier 1 and the ejector 4 is achieved in two ways, by providing the fluorine gas purging line 420. The two ways of achieving the connection are (i) a method in which the diluent gas supplier 1 is connected to the ejector 4 via the pressure dampening tank 12, the mass flow controller 3a, and the heater 8, and (ii) a method in which the diluent gas supplier 1 is connected to the ejector 4 without the intervention of the pressure dampening tank 12, the mass flow controller 3a, and the heater 8.

The pressure control apparatus (pressure control unit) 430 recognizes the pressures on the upstream side (inlet) and the downstream side (outlet) of the mass flow controller 3a with reference to measurement results of the pressure gauges 9 and 10, figures out instruction values of the pressure gauges 9 and 10, and calculates a primary pressure to be applied to the mass flow controller 3a. This calculation result is sent to the pressure adjusting valve 11 as an instruction. Receiving the instruction, the pressure adjusting valve 11 adjusts the open/close condition of the valve. In this way, the primary pressure applied to the mass flow controller 3a is controlled.

As described above, the surface treatment apparatus 400 of the modification is able to achieve effect similar to those of First Embodiment. Furthermore, by using the diluent gas discharging pipe 410, the back pressure valve 414, and the diluent gas discharge valve 415, it is possible to discharge diluent gas from the diluent gas discharging pipe 410 without allowing the diluent gas to contact the fluorine gas until the diluent gas is heated to a predetermined temperature by the heater 8. With this, it is possible to supply the diluent gas with a desired temperature to the mixer 5, right after the start of the supply. Furthermore, to cool the heater 8 by using the diluent gas, used diluent gas is exhausted by using the diluent gas discharging pipe 410, the back pressure valve 414, and the diluent gas discharge valve 415. This makes it possible to supply the diluent gas at a desired flow rate and to rapidly cool the heater 8.

In addition to the above, to purge the fluorine gas in the pipes and components on the downstream of the ejector 4 by the diluent gas after the reaction of the treatment target in the reactor 6, it is unnecessary to heat the diluent gas. On this account, it is possible to rapidly and efficiently purge the fluorine gas at a desired flow rate by non-heated diluent gas, by introducing the diluent gas supplied from the diluent gas supplier 1 to the ejector 4 by using the fluorine gas purging line 420.

The surface treatment apparatus of the embodiments of the present invention and the reactor of the modifications have been described. It is noted that the present invention is not limited to the embodiments and modifications above, and can be variously changed within the scope of claims. For example, in the embodiments above, a heat-retaining material may be provided at a non-edge part of the pipe connecting the ejector with the mixer or on the pipe on the downstream of the mixer. This heat-retaining material reduces influences of outside temperatures, and hence the mixed gas with a high temperature is supplied to the reactor without losing heat. This makes it possible to prevent the occurrence of treatment irregularities and to further improve the treatment efficiency.

In the embodiments above, two or more reactors may be provided. In such a case, the surface treatment apparatus is arranged so that at least one reactor is used as the reactor, whereas the remaining reactor (s) is used as a heating chamber.

In the embodiments above, a valve may be additionally provided to be able to shut off each of the components constituting the surface treatment apparatus. At least one of or all of such valves may be an automatic valve, a manual valve, or the like.

In the embodiments above, the plate member provided between the mixed gas and the treatment target may be detachable or may be fixed to the reactor or the movable member.

In addition to the above, in First Embodiment, an exhauster or the like may be additionally provided between the reactor and the harm removal apparatus. This exhauster facilitates exhausting of the mixed gas from the reactor.

In the embodiments above, a pipe may be additionally provided to introduce the gas exhausted from the reactor to the fluorine gas supplier and the diluent gas supplier. This makes it possible to reuse the fluorine gas and the diluent gas included in the gas exhausted from the reactor, and reduces an amount of the fluorine gas treated by the harm removal apparatus.

In addition to the above, although the number of harm removal towers in the harm removal apparatus is three in Second Embodiment, the number of towers may be four or more. The number of harm removal towers connected in series with each other is not limited to two, and hence the number of such towers may be three or more. The number of independently-connected harm removal towers is not limited to one, and hence the number of such towers may be two or more.

In addition to the above, the pressure control apparatus 430 of the surface treatment apparatus 400 in the modification may be provided in each of the surface treatment apparatuses 100 and 200 of the embodiments above. Since this makes it possible to control a primary pressure (inlet pressure) on the mass flow controller 3a, the diluent gas is stably supplied.

## Claims

1. A surface treatment apparatus comprising:
a diluent gas supplier which supplies a diluent gas;
a fluorine gas supplier which supplies a fluorine gas;
a mixer which generates a mixed gas by mixing the diluent gas with the fluorine gas;
a surface treatment apparatus which includes a reactor causing the mixed gas to contact a treatment target; and
a surface treatment apparatus which includes a heating unit heating the diluent gas.

2. The surface treatment apparatus according to claim 1, wherein,
the heating unit heats the diluent gas before the diluent gas is mixed with the fluorine gas.

3. The surface treatment apparatus according to claim 1 or 2, further comprising:
an ejector which sucks the fluorine gas by using the diluent gas as a drive source.

4. The surface treatment apparatus according to any one of claims 1 to 3, further comprising:
a first flow control unit which is connected to the diluent gas supplier and the mixer;
pressure gauges which are provided on the upstream and downstream of the first flow control unit, respectively; and
a pressure adjusting valve which is connected to the diluent gas supplier and the pressure gauge on the upstream of the first flow control unit.

5. The surface treatment apparatus according to any one of claims 1 to 4, further comprising:
a pressure dampening tank which is provided between the pressure adjusting valve and the pressure gauge on the upstream of the first flow control unit.

6. The surface treatment apparatus according to any one of claims 1 to 5, further comprising:
a second flow control unit connected to the fluorine gas supplier and the mixer.

7. The surface treatment apparatus according to any one of claims 1 to 6, further comprising:
a first communicating tube which is connected to the mixer;
a back pressure valve which is provided at a non-edge part of the first communicating tube;
a gas discharge valve which is provided at a non-edge part of the first communicating tube, the non-edge part being on the downstream of the back pressure valve;
a second communicating tube which connects the mixer with the reactor; and
a gas introducing valve which is provided at a non-edge part of the second communicating tube.

8. A surface treatment apparatus comprising:
a diluent gas supplier which supplies a diluent gas;
a fluorine gas supplier which supplies a fluorine gas;
a mixer which generates a mixed gas by mixing the diluent gas with the fluorine gas;
a surface treatment apparatus which includes a reactor which causes the mixed gas to contact a treatment target;
an exhauster which exhausts an exhaust gas from the reactor;
plural flow paths which are provided between the reactor and the exhauster and through which the exhaust gas passes; and
plural valves which are provided on the flow paths, respectively.

9. The surface treatment apparatus according to claim 8, further comprising:
a harm removal apparatus which is connected to the exhauster.

10. The surface treatment apparatus according to claim 8 or 9, wherein,
each of components existing in a range from an outlet of the reactor to an inlet of the harm removal apparatus has a heating/heat-retaining unit, and
an internal temperature of each of the components is equal to or higher than the boiling temperature of hydrogen fluoride.

11. The surface treatment apparatus according to any one of claims 8 to 10, wherein,
the harm removal apparatus includes plural harm removal towers, and
among the plural harm removal towers, at least one of the harm removal towers is independently connected, whereas the remaining at least two towers different from the independently-connected tower are connected in series with each other.

12. The surface treatment apparatus according to any one of claims 1 to 11, further comprising:
a heating chamber which heats the treatment target.

13. The surface treatment apparatus according to any one of claims 1 to 12, further comprising:
a movable member which is capable of transporting the treatment target into the reactor and has fluorine gas corrosion resistance.

14. The surface treatment apparatus according to any one of claims 1 to 13, further comprising:
in the reactor, a plate member which is provided between the treatment target and the mixed gas supplied to the reactor.

15. The surface treatment apparatus according to claim 13, further comprising:
on the movable member, a plate member which is provided between the treatment target and the mixed gas supplied to the reactor.
